# EUROPEAN PATENT APPLICATION

(11) **EP 1 892 771 A1**
(43) Date of publication of application: **27.02.2008**
(21) Application number: 06725820.2
(22) Date of filing: 16.03.2006
(51) Int. Cl.: H01L 31/052, H01L 31/042, F24J 2/38

(54) **SUBMODULE FOR PHOTOVOLTAIC CONCENTRATION MODULES, PHOTOVOLTAIC CONCENTRATION MODULE, SOLAR POWER INSTALLATION, PACKING METHOD AND POSITION CALIBRATION METHOD FOR PHOTOVOLTAIC CONCENTRATION MODULES**

(30) Priority: 27.04.2005 ES 200501024
(71) Applicant: SOL3G, S.L., 08290 Barcelona (ES)
(72) Inventor: PARDELL VILELLA, Ricard., E-08197 Valldoreix Barcelona (ES)
(74) Representative: Isern-Jara, Nuria
(86) International application number: PCT/ES2006/000130
(87) International publication number: WO 2006/114457

(57) **Abstract**

The invention relates to a photovoltaic concentration submodule (1) for photovoltaic concentration modules, including solar energy concentrators which are used to capture solar radiation and which comprise Fresnel lenses (15) and secondary optical elements. The inventive submodule is formed by a laminar body (2) comprising a central section and two essentially-perpendicular lateral flanges, such as to define an essentially U-shaped element which is made from aluminium. According to the invention, fixing means are used to fix photovoltaic cells to the central section, which are supplied to each of the concentrators. The aforementioned laminar body (2) serves as a support structure for the concentrators and as a heat-dissipating element for the photovoltaic cells. Moreover, the Fresnel lenses are disposed on a front mount (3) which is joined with the laminar body (2), said lenses being disposed in a row.

## Description

### OBJECT OF THE INVENTION

The present Invention refers to a sub-module for application with photovoltaic concentration modules, a photovoltaic concentration module, a solar power installation and a packing method for the stated modules, which incorporate appreciable innovations and advantages compared to the currently known systems for the generation of solar power from solar radiation.

More specifically the object of the invention relates to a sub-module, a photovoltaic concentration module that incorporates the above sub-module and a solar power installation that uses the above-mentioned concentration module for installation on flat surfaces, such as the roofs of buildings such as dwellings, office buildings, factories and warehouses, likewise on pergola type structures for car parks, stations and stopping points for public and private transport, walkways, green areas and agricultural operations.

### BACKGROUND TO THE INVENTION

In general, the main benefit sought by photovoltaic concentration systems is cost reduction by means of the reducing of the photovoltaic device surface area.

The concentration of the radiation demands an active follow up for the solar path by the concentrator system, in contrast to the current flat photovoltaic panels, without concentration, in which the possibility of solar follow up of the system is optional. The precision with which the said follow up is carried out must be greater the greater the degree of the required solar concentration.

The known photovoltaic concentration assemblies with follow up on two axes for the generation of electrical power from solar radiation are normally made up from a plurality of modules, each one of which has at least a pair of lens assemblies or "parquets". Each lens assembly has a transparent laminar body that can include, for example, a set with a specific number of lenses that focus the solar radiation onto a set of solar cells located inside the module. The advantage of the use of the solar or photovoltaic cells is that they are devices capable of converting solar radiation into electricity, in a direct manner.

On the other hand, a wide variety of invention applications are known that are related to the design and structures for the formation of photovoltaic assemblies of the above-described type, such as, for example, the application EP 0581 889 that describes a photovoltaic assembly for the generation of electrical power from solar radiation formed by a multiplicity of lens assemblies.

However, owing to the costs of manufacturing the components and the maintenance involved nowadays in the installation of these types of structures, it gives rise to the fact that now this type of application is not as requested as would be desirable as there are a series of problems that have not yet been solved.

In addition, the known photovoltaic concentration devices are very difficult to install on the roofs of buildings or other types of exploitations of secondary surfaces, their use being limited to centralised production on land that is dedicated to it. This is due to their high centre of gravity and disadvantageous aerodynamics, which also has a negative effect on their operational capacity in areas subjected to sustained winds.

Another problem associated with the photovoltaic concentration systems is the dissipation of heat. There is a direct relationship between the degree of concentration and the cost reduction benefits by the reduction of the photovoltaic device surface area which, however, has a negative effect offset by the increased cost involved in the need to dissipate more heat on a more reduced surface.

### DESCRIPTION OF THE INVENTION

This present invention has been developed for the purpose of providing a sub-module for application with photovoltaic concentration modules, a photovoltaic concentration module, and a solar power installation that solves the previously stated disadvantages, in addition providing other additional advantages that will become clear from the description that is included below.

The photovoltaic concentration module of the present invention in particular applicable to noticeably flat surfaces is characterised in that it is made up of a plurality of sub-modules of the type that are described below arranged in a parallel and equidistant manner to each other that are supported on a platform that is fitted in an appreciably horizontal manner compared to the support surface or equally to the ground (this means, it is essentially parallel to the surface on which the entirety of the module rests), said platform being arranged on a support structure to be fitted to the surface of the roof or support surface, in addition including electro-mechanical means of movement fitted with two axes in order to follow the sun's path, one of the two axes being fitted to the turning movement of the sub-module and the other axis fitted to the turning movement of the platform.

It must be highlighted that the axis fitted to the turning movement of the sub-module follows an altitude path, this means, that it turns on a geometric axis parallel to the horizontal plane, whilst the other axis is connected to the turning movement of the platform thus corresponding to the azimuth path, this means, it turns on a geometric axis perpendicular to the horizontal plane, and because of the fact that each turning movement is connected by means of a separate motor for each movement.

Each module object of the invention is designed to provide around 200 watts of power with an ambient temperature of 25° C., however the system is basically scaleable, hence modules can be made with appreciably higher or lower powers that are based on the same principles.

This present invention introduces a dissipation system suited to a high concentration (of the order of 400 to 500 suns) onto multi-union photovoltaic cells of at least one square centimetre. The new system of dissipation is at the same time economical and efficient, with which the cost reduction introduced by the reduction of the photovoltaic surface element is not negatively offset by the additional cost of the dissipation system.

Thanks to these characteristics, a photovoltaic concentration module is obtained to be installed on the roofs of buildings with a flat surface, not requiring a large surface for the assembly of an installation of the type of module described above. In addition, its installation is simple to carry out as it does not need the use of anchoring or other additional fixing elements (due to the relatively low centre of gravity position), reducing the number of workers necessary to carry out said installation and being adapted to the working regulations that refer to lifting and handling of heavy loads. Its low aerodynamic profile allows its use with strong winds and offers a reduced visual impact owing to the flattened arrangement of the module, unlike other concentration systems that follow two axes, generally formed by panels arranged on posts that are perpendicular to the ground with a centre of gravity that is considerably high and a significant visual impact.

In addition, another advantageous aspect of the photovoltaic module compared to other known systems, as that previously mentioned in the background to the invention, is the fact that it requires little height (and therefore a lower centre of gravity position), in such a way that they reduce the visual impact unlike, for example, the system described in the previously referred to patent.

The module can be fitted with some means for calculating the positioning and for the following of the sun based on the astronomical axes of altitude and azimuth (the invention not being limited solely and exclusively to said astronomical axes) for the purpose of obtaining the maximum degree of concentration, means of geographical positioning and orientation and a solar radiation sensor, said means being fitted to the electro-mechanical means of turn. By means of the presence of said solar radiation sensor, the module has a capacity to determine if the light conditions in the sky are adequate to calibrate the most suitable position in line with the presence of clouds or not. It is worth mentioning that the following of the sun is carried out on the basis of the altitude and azimuth parameters, and therefore, on two axes in such a way that the concentration of the sun is greater compared to the known solar power collection systems of the stationary type or with one single tracking axis.

It is the object of the invention to provide a photovoltaic concentration sub-module for photovoltaic concentration modules, that includes solar power concentrators for the capture of solar radiation, said concentrators being fitted with Fresnel lenses and secondary optical elements, that are characterised because the sub-module is formed by a laminar body with a centre section and two side wings that are appreciably perpendicular defining an appreciably U shape made from aluminium onto which the photovoltaic cells are fixed on the centre section by a means of fixing that is provided for each one of the concentrators, the laminar body acts as a support structure for the concentrators and the heat dissipater element for the photovoltaic cells, and because the Fresnel lenses are arranged in a frontal mount that is fitted to the laminar body, said lenses being fitted in a row.

In this way, thanks to the arrangement of the U shaped support structure the metallic dissipation surface is increased in a simple manner and at a low cost, for example, compared to the European patent previously stated in the background to the invention, where the dissipation surface practically equates to the area occupied by the optical concentrator elements unlike the present application, where said dissipation surface is approximately equivalent to 4 times the area occupied by the optical concentrator elements.

Advantageously, the fixing means include a silver based epoxy resin that is a heat transmitter and an electrical insulator.

On the other hand, also thanks to the design likewise the size of the different components that make up the modules it can be easily transported on pallets. In this way the transport costs are reduced.

Another aim of the invention is to provide an installation for the conversion of solar power into electrical energy that is made up of a plurality of photovoltaic concentration modules of the type that has been previously described here, being coupled to each other by laterals defined each one of the support base structures with a hexagonal shape and each one of the modules aimed in the same direction. This installation is very suitable for fitting on the roofs or terraces of dwellings, blocks of flats, office buildings, warehouses, etc.

In accordance with another aspect of the invention, the installation will be made up by one or more groups of modules, or clusters, where each cluster includes a master module and a plurality of slave modules connected to each other and controlled by the master module. The master module includes the means for the controlling of the positioning and to be able to follow the sun, some means of communication for the control of the slave modules and a solar radiation sensor.

Thanks to the fitting of all of these additional elements in a single module of each cluster of the installation, a saving is made in the manufacture, maintenance and energy required for the working of the installation as it avoids each one of the modules that make up an installation having to have all of these additional elements, there being only the master module in a state of constant monitoring and control, and the slave modules passively obeying the orders periodically sent by the master module, hence these are in a "state of sleep" for the greater part of the time, in this way minimising the parasitic consumptions as a result of the monitoring and control. All of these modules are connected to a data bus that allows the exchange of orders and responses between the master module and the slave modules. The decentralisation of the system likewise allows the installation to be monitored at a modular level, which allows the maximum information to be obtained from the installation for the purpose of optimising the maintenance intervention.

It must be highlighted that the movements made by the module movement means are angular movements that are carried out at intervals predetermined on the basis of the acceptance angle of the solar energy concentrator.

Another aim of this present invention is to provide a package for a plurality of photovoltaic concentration modules that is made up of a pallet which has a plurality of aligned modules on the top and in a vertical position. In this way the logistical costs are minimised for the transport of the components of the installation from the point of pre-assembly to the installation assembly point.

Other characteristics and advantages of the photovoltaic concentration module and the solar power installation object of the present invention will be come clear from the present description of a preferred embodiment, but not exclusive, shown by way of non limitative example, in the following drawings, in which:

### BRIEF DESCRIPTION OF THE DRAWINGS

Figure 1 shows a perspective view of the photovoltaic concentration sub-module object of this present invention in an unassembled position;
Figure 2 shows detailed perspective view of a section of the sub-module of Figure 1 that includes a photovoltaic cell and a Fresnel lens;
Figure 3 shows a perspective view of the photovoltaic concentration module object of this present invention;
Figure 4 shows a perspective view of an embodiment of a solar power installation that includes the modules shown in Figure 3;
Figure 5 shows a perspective view of a solar power installation with a pergola arrangement;
Figure 6 shows a perspective view of an arrangement of the package of 4 modules of the invention;
Figure 7 shows a diagram of an installation of this present invention;
Figure 8 shows a diagrammatic view of another embodiment of a solar power installation of this present invention; and
Figure 9 shows a diagrammatic view of yet another embodiment of a solar power installation with the sub-modules of this present invention.

### DESCRIPTION OF A PREFERRED EMBODIMENT

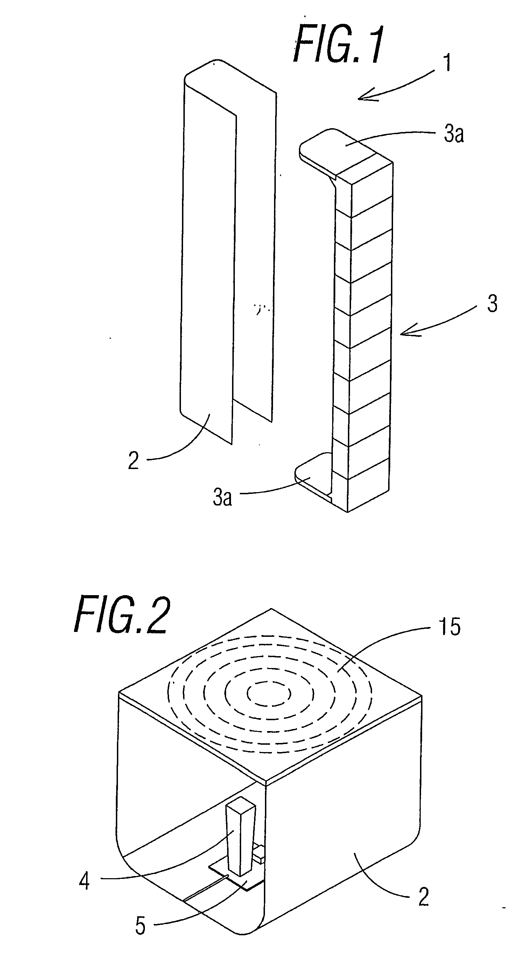

As and how shown in figure 1, the photovoltaic concentration sub-modules (1) for photovoltaic concentration modules that will be explained in greater detail later, are made up of ten solar power concentrators for the collection of solar radiation, each one of the solar power concentrators being made up of a Fresnel lens (15) and a secondary optical element, which enables an increase in the level of concentration, the angle of acceptance and uniform illumination of the cell, thus improving the performance and the tolerance of the concentrators. Said sub-module (1) is made up of a laminar body (2) with a thickness equal to or less than 1 mm. with a flat central area and two side flanges that are appreciably perpendicular, and in so doing forming a U shape. The laminar body (2) is made from aluminium onto which the central section is fitted by some means of fixing, such as silver based epoxy resin that is a heat transmitter and an electrical insulator, photovoltaic cells that are provided to each one of the concentrators. It must be highlighted that U shaped laminar body (2) acts as a support structure for the concentrators and as a heat dissipater element for the photovoltaic cells.

The Fresnel lenses (15) (these will not be explained in greater detail as they are not the object of the invention) are fitted into a housing located in a frontal mount (3) fixed to the laminar body (2), said lenses (15) being fitted in a single row as can be seen in Figure 1.

The photovoltaic cells (4) have, for example, dimensions of 5.5 x 5.5 mm., each one of them being mounted onto a metallised ceramic substrate (5) that includes a protection by-pass diode and said cells (4) are linked to the secondary optical elements (manufactured from glass) by means of a transparent silicone elastomer (see figure 2).

The stated front mount (3) is made up from a body made from a plastic material that has a low manufacturing cost onto the front of which the Fresnel lenses (15) are fitted, the sides of the sub-module (1) being closed by said body by means of some side extensions (3a) and the front by the lenses themselves, in such a way that the inside of the sub-module (1) is hermetically sealed when they are fitted together with the laminar body, some silicone being applied for the fixing of both.

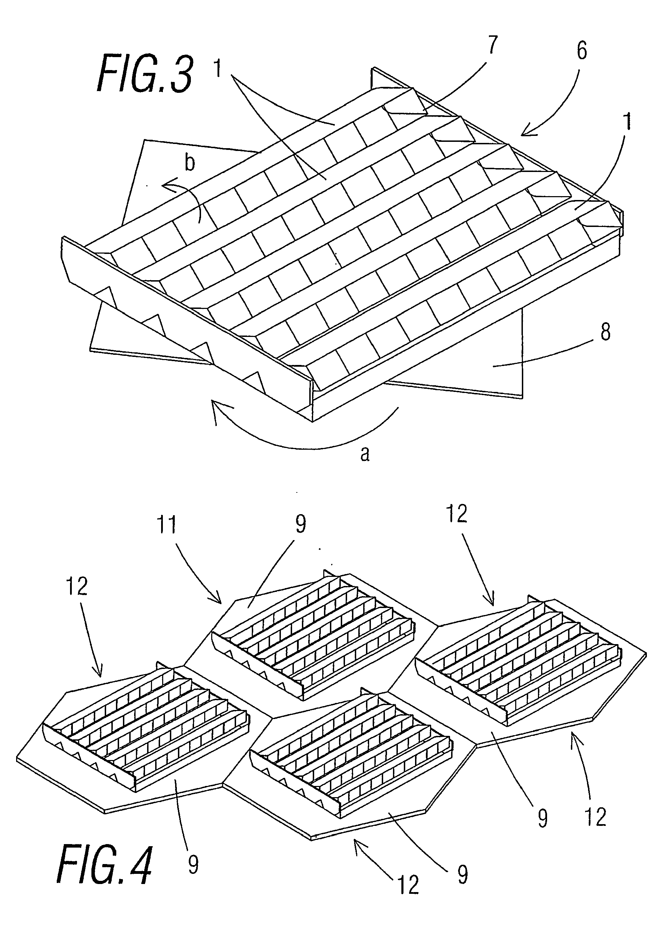

As can be seen from figure 3, the photovoltaic concentration module (6) is made up of five sub-modules (1) grouped together in a parallel and equidistant manner that are supported on a single platform (7) that includes a lower horizontal support plate (8). Each module (6) can give approximately 200 watts of power. Each one of the modules (6) is fitted with a electro-mechanical device for the movement along the two axes, one of the axes for the turning movement of the platform and the other axis in order to move each one of the modules to follow the position of the sun, with which there are at least two conventional electric motors included that enable the sun to be followed both along the azimuth axis and equally on the altitude axis. Such movements along the two astronomical axes are more clearly shown in figure 3 by means of the two arrows shown, arrow (a) showing the module following the azimuth and arrow (b) the module following the altitude.

By preference, the platform (7) is made up of five sub-modules (1) arranged in a parallel and equidistant manner, the complete assembly thus having a generally flat arrangement.

The module (6) can rest on a positioning base (9) that advantageously has a hexagonal shape. Said geometric arrangement has the advantage that it makes the alignment operations easier during the assembly operation of a solar power installation. This is due to the fact that starting out from the alignment of a single base (9), taking advantage of the regular hexagonal geometry, the rest of the bases (9) can be aligned by means of the simple fitting together of multiple bases (9) using the regular sides of same.

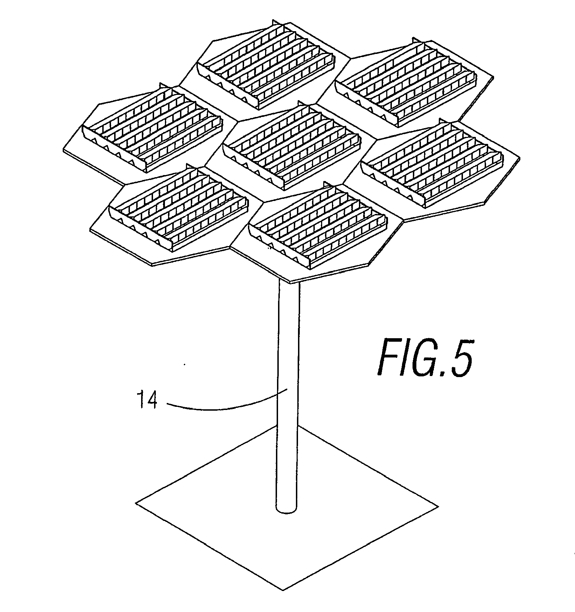

More specifically, the positioning base (9) is formed from a plurality of elements (10) with a regular trapezoidal shape (see figure 5), which once connected to each other make up a hexagonal shape. In this way, by means of the use of parts that can be dismantled the transport operation is made easy as it occupies less space in a state prior to the assembly and the assembly of the bases (9) is thus simple and quick.

One or several photovoltaic concentration module (6) can be provided with devices for the calculation of the positioning and following of the sun connected to the electro-mechanical means of turning, means of positioning and geographical orientation and a solar radiation sensor that allows the solar radiation to be measured.

Said geographical positioning and orientation devices consist of a GPS positioning system to allow the latitude and longitude to be known of the geographical location where the module is being installed, and the time variables (such as the GMT time and date) thus allowing the astronomical calculation of the sun's position to be made, so that the modules (6) are directed in the sun direction. Further, the geographical positioning and orientation devices can include a conventional compass (not shown).

On the other hand, a plurality of photovoltaic concentration modules (6) can be grouped together to create an installation for the conversion of solar power into electrical energy, said modules (6) being fitted together by the laterals that are made with a hexagonal shape to each one of the support base structures (9). All of the modules (6) will be directed in the same direction or cardinal point, as can be seen in figure 4, so as to make the operations of following the sun easier.

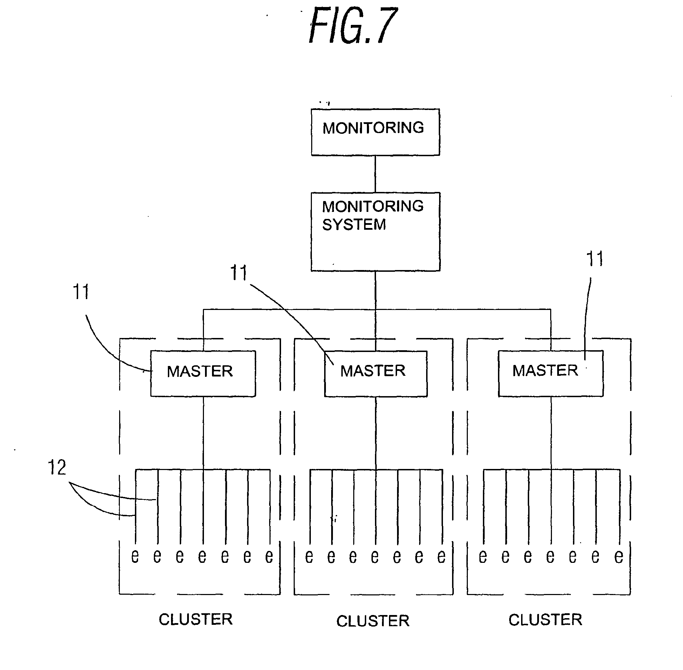

As and how can be seen in the diagram in figure 7, the installation is remotely monitored from any determined point is divided into clusters, each one of which is basically made up of a master module (11) and a plurality of slave modules (12) connected to each other and controlled by the master module (11), said master module (11) having some means of calculating the position and following of the sun (calculation based on altitude and azimuth), some means of control to control the slave units (12) and a solar radiation sensor aimed at the zenith. The rest of the electro-mechanical, mechanical and optical components are common in both types of module (11) and (12).

The movements made by the module movement devices (6) are angular and are carried out at predetermined intervals, following an open loop control strategy, on the basis of a solar power concentrator acceptance angle of 1.25°. Approximately every four minutes, the master module (11) recalculates the position of the sun and orders the slave modules (12) to make the required movements.

During the installation process, the master module (11) will carry out an initial calibration procedure that consists of determining the deviation of the azimuth and altitude axes compared to the theoretical axes. Said procedure has the following stages: In the first place, look for the sun's theoretical position from an astronomical calculation. In the case in which the sun is found within the field of view of the module, centre the image within said field of view by means of diagonal movements. In the event of not finding the sun within the field of view of the module, proceed to make spiral movements until it finds the sun within the field of view, and starting out from there proceed as in the previous case. Once having finalised said procedure the master module will calculate the angles of deviation of the axes staring from the difference between the observed position of the sun and its position provisioned from the astronomical calculation. In said procedure the master module (11) acts following a closed loop control strategy, re-fed by the power generated by the module itself, which in this case acts as a photometer.

Likewise, the master module will calculate the positioning errors of all of its slave modules executing the same calibration procedure for each one of them, but starting out from the corrected position in accordance with the error parameters of the master module itself. In this way the master module gathers the entirety of the initial vectors of the positioning error parameters from the entire cluster of modules that it controls in a matrix. From the error parameters the master module will correct the astronomical position of the sun in the subsequent positioning orders that it sends to all of the modules in the cluster during the following operations.

The solar radiation sensor aimed towards the zenith is used by the master module in order to decide when to carry out the calibration process, as it is not possible to carry it out with completely or partially clouded skies, likewise to have an external reference that enables an evaluation of the total performance of the system.

On the other hand, the master system will be responsible for obtaining measurements of power at specific moments from the slave modules for the purpose of detecting the important deviations of performance. When the master module detects that some of the slave modules in the cluster are performing appreciably below the average level, the master module will proceed with the re-calibration of the affected slave module following the same procedures as during the installation process. Said procedure, as has already been mentioned, is only carried out if the solar radiation conditions allow it, and not at any moment. If the calibration process does not succeed, then the master system will generate an alarm to send to the installation supervision system. This means that the differing master modules (one per cluster) of the installation will be connected to a general monitoring system of same, which must, by preference, be fitted with some means of telematic communication that will allow its remote supervision.

In figure 5, there is a second preferred embodiment shown of the here described installation that has a pergola configuration, in such a way that it can be installed on the ground in such a way that the surface of the ground can be used on only having an anchoring bar element (14). This arrangement could be suitable for application on vehicle parking areas or gardens.

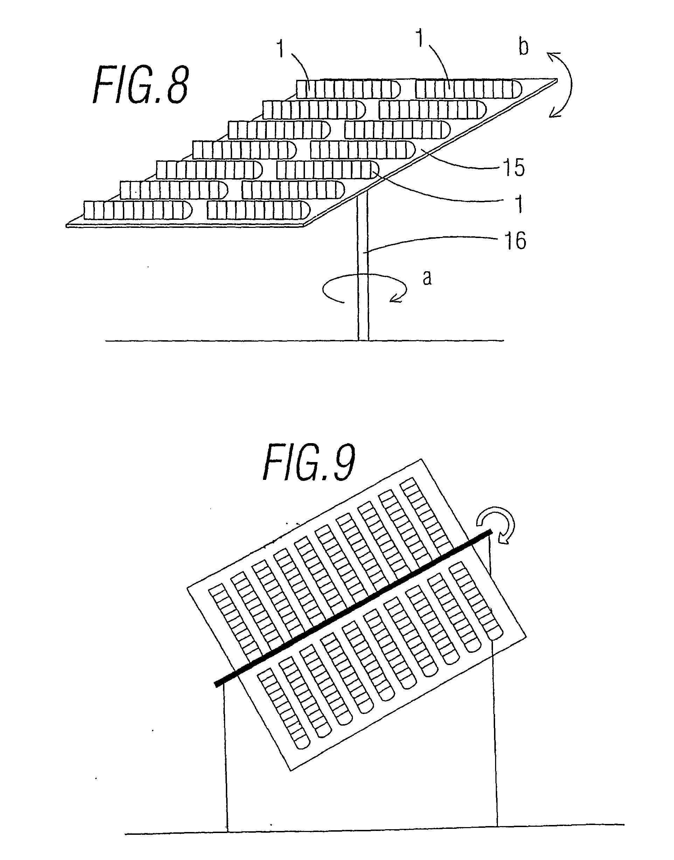

In figure 8 another embodiment is shown of the photovoltaic concentration in which the sub-modules (1) are arranged on a raised platform (15) above floor level by means of a turning pivoting point (16) on its own longitudinal axis, in such a way that the platform carries out the azimut following and the movement of the sub-modules themselves carry out the following of the altitude path.

Additionally, figure 9 shows another alternative embodiment of the photovoltaic concentration installation in a diagrammatic manner which uses the here described sub-modules in which two different path following axes have been used: the declination axis and the ascent axis.

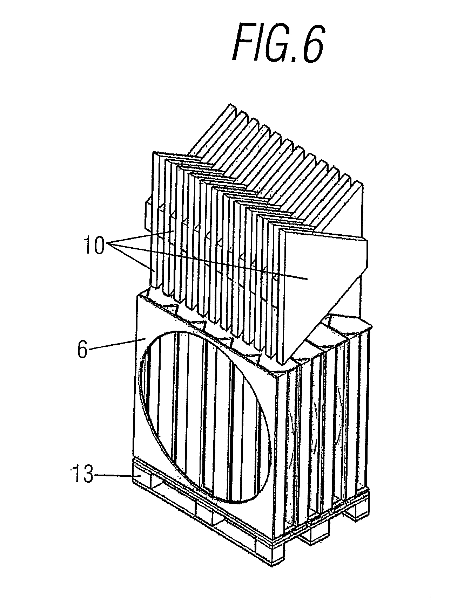

As and how can be seen in figure 6, the components that make up an installation can be transported in a simple and quick manner and at relatively low cost by means of a suitable form of packaging. Said packaging is made up of a pallet (13) onto which four modules (6) are placed on the upper part and in a vertical position which are aligned, said pallet (13) preferably having measurements of 1200 x 800 mm., in such a way that four modules (6) of the invention are aligned. There is also the possibility of using a 1200 x 1200 mm. pallet so that six modules (6) are aligned.

The packaging can include a plurality of the elements (10) that have the trapezoidal shape arranged in a row on the highest part.

The details, shapes, sizes and other accessorial elements, likewise the materials used in the manufacture of the photovoltaic concentration module likewise in the installation of the invention can be appropriately substituted by others that are technically equivalent and do not stray away from the essentiality of the invention or the scope defined by the claims that are included below.

## Claims

1. A photovoltaic concentration sub-module (1) for photovoltaic concentration modules are made up of solar power concentrators for the collection of solar radiation, each one of the solar power concentrators comprising Fresnel lenses (15) and secondary optical elements, **characterised in that** the sub-module is made up of a laminar body (2) with a flat central area and two side flanges that are appreciably perpendicular, and in so doing forming a U shape, and is made from aluminium onto which the central section is fitted, photovoltaic cells that are provided to each one of the concentrators the laminar body (2) acting as a support structure for the concentrators and heat dissipater element for the photovoltaic cells, and **in that** the Fresnel lenses are fitted into a housing located in a frontal mount (3) fixed to the laminar body (2), said lenses being fitted in a single row.

2. A photovoltaic concentration sub-module (1), according to claim 1, **characterised in that** the means of fixing is made by a silver based epoxy resin that is a heat transmitter.

3. A photovoltaic concentration sub-module (1), according to claim 1, **characterised in that** each one of the photovoltaic cells is assembled onto a metallised ceramic substrate that has a by-pass diode for protection and said cells being joined by secondary optical elements by means of a transparent elastomeric silicone.

4. A photovoltaic concentration sub-module (1), according to claims 1 and 3, **characterised in that** the photovoltaic cells have dimensions of 5.5 x 5.5 mm.

5. A photovoltaic concentration sub-module (1), according to claim 1, **characterised in that** the U shaped laminar body (2) has a thickness that is equal to or less than 1 mm.

6. A photovoltaic concentration sub-module (1), according to claim 1, **characterised in that** the front mount (3) is made up from a laminar body made from a transparent plastic material that makes up a lens assembly that focuses the solar radiation onto a set of solar cells located inside the sub-module, onto which the lenses are fitted and which have some side extensions (3a) so that they are fitted together with the laminar body (2), the inside of the sub-module is hermetically sealed.

7. A photovoltaic concentration module (6), especially suitable for appreciably flat surfaces **characterised in that** it is made up of a plurality of sub-modules (1), according to claims 1 to 6 and arranged in a parallel and equidistant manner with each other, there being a plurality of sub-modules supported on a platform that is appreciably horizontal compared to the support surface, said platform being arranged on a support structure to be placed on a roof surface or support surface and in addition including electro-mechanical means of movement associated to the movement on two axes so as to follow the path of the sun, one of the axes being connected to the turning movement of the sub-module (1) and the other axis connected to the turning movement of the platform (7).

8. A photovoltaic concentration module (6), according to claim 7, **characterised in that** the axis connected to the turning movement of the sub-module (1) corresponds to the following of the altitude whilst the other axis connected to the turning movement of the platform (7) corresponds to the following of the azimuth and because each turning movement is driven by an independent motor.

9. A photovoltaic concentration module (6), according to claim 7, **characterised in that** the platform has five sub-modules arranged in an equidistant and parallel manner.

10. A photovoltaic concentration module (6), according to claim 7, **characterised in that** it includes a positioning base (9) onto which the support structure rests, said base (9) having hexagonal shape.

11. A photovoltaic concentration module (6), according to claim 9, **characterised in that** the positioning base (9) is made from a plurality of elements (10) that have a trapezoidal shape, which are inter-connectable with each other in such a way that in an assembled manner they define the hexagonal shape of the base (9).

12. A photovoltaic concentration module (6), according to claim 7, **characterised in that** it is provided with a means of calculation for the positioning and following of the sun based on the altitude and azimuth axes, a means of geographical positioning and orientation and a solar radiation sensor, said means being connected to the electro-mechanical turning movement devices.

13. A photovoltaic concentration module (6), according to claim 11, **characterised in that** the means of geographical positioning and orientation include a GPS positioning system.

14. A photovoltaic concentration module (6), according to claim 11, **characterised in that** the means of geographical positioning and orientation include a compass.

15. An installation for the conversion of solar power into electrical energy **characterised in that** it has a plurality of photovoltaic concentration modules (6), according to claims 7 to 14, the modules (6) being fitted to each other by their geometric sides to each one of the hexagonally shaped support base structures and all of the modules (6) being aimed in the same direction.

16. An installation for the conversion of solar power into electrical energy, according to claim 15, **characterised in that** it is divided up into a number of clusters, each one of which includes a master module (11) and a plurality of slave modules (12) connected to and controlled by the master module (11).

17. An installation for the conversion of solar power into electrical energy, according to claim 16, **characterised in that** the master module (11) includes the means for the calculation for the positioning and following of the sun, a control means to control the slave modules (12) and a solar radiation sensor.

18. An installation for the conversion of solar power into electrical energy, according to claim 16, **characterised in that** the movements carried out by the movement devices of the modules are angular movements that are carried out at predetermined intervals on the basis of the angle of acceptance of the solar energy concentrator.

19. An installation for the conversion of solar power into electrical energy, according to claims 15 to 18, **characterised in that** it is made from a plurality of clusters, each cluster being made from a master module (11) and a plurality of slave modules (12).

20. A method of packaging for a plurality of photovoltaic concentration modules according to any of claims 7 to 14, **characterised in that** it includes a pallet (13) onto which a plurality of aligned modules (6) are place on the upper part and in a vertical manner.

21. A method of packaging according to claim 20, **characterised in that** the pallet has measurements of 1200 x 1200 mm, said pallet containing six modules aligned in a vertical position.

22. A method of packaging according to claim 20, **characterised in that** the pallet has measurements of 1200 x 800 mm, said pallet containing four modules aligned in a vertical position.

23. A method of packaging according to claim 20, **characterised in that** it has a plurality of elements (10) that have a trapezoidal shape arranged in a row.

24. A procedure for the calibration of photovoltaic concentration module positions for the position of the sun in the field of view for the photovoltaic concentration modules of an installation of the type described in claims 15 to 19 **characterised in that** it has the following stages:
a. The search for the sun in its theoretical position starting out from the astronomical calculation;
b. (i) The centring of its image within said field of view by means of diagonal movements in the case of finding the sun within the field of view of the module and (ii) it proceeds to carry out spiral movements until it finds the sun in the field of view in the event of not finding the sun in the field of view of the module;
c. The master module calculates the angles of deviation of the axes from the difference between the position observed of the sun and the position forecast from the astronomical calculation;
d. The master module calculates the positioning errors of all of the slave modules performing the same calibration procedure for each one of them, but starting out from the corrected position in accordance with the error parameters of the master module; and
e. The master module corrects the astronomical position of the sun in the subsequent positioning orders that it sends to all of the modules in the cluster during the following operations from the error parameters.

## Amended claims

### Amended claims under Art. 19.1 PCT

**1.** A photovoltaic concentration sub-module (1) for photovoltaic concentration modules are made up of solar power concentrators for the collection of solar radiation, each one of the solar power concentrators comprising Fresnel lenses (15) and secondary optical elements, **characterised in that** the sub-module is made up of a laminar body (2) with a flat central area and two side flanges that are appreciably perpendicular, and in so doing forming a U shape, and is made from aluminium onto which the central section is fitted, photovoltaic cells that are provided to each one of the concentrators, the laminar body (2) acting as a support structure for the concentrators without the use of structural reinforcement and said element also acts as a heat dissipater element for the photovoltaic cells, and **in that** the Fresnel lenses are fitted into a housing located in a frontal mount (3) fixed to the laminar body (2), said lenses being fitted in a single row,
with a geometry such that the heat dissipation surface is at least three and one half times greater than that occupied by the Fresnel lenses (15), said front mount (3) being made up from a laminar body made from a transparent plastic material that makes up a lens assembly that focuses the solar radiation onto a set of solar cells located inside the sub-module, onto which the lenses are fitted and which have some side extensions (3a) so that they are fitted together with the laminar body (2), and when said coupling is made with an adhesive, the inside of the sub-module is hermetically sealed.

**2.** A photovoltaic concentration sub-module (1), according to claim 1, **characterised in that** the means of fixing is made by a silver based epoxy resin that is a heat transmitter.

**3.** A photovoltaic concentration sub-module (1), according to claim 1, **characterised in that** each one of the photovoltaic cells is assembled onto a metallised ceramic substrate that has a by-pass diode for protection and said cells being joined by secondary optical elements by means of a transparent elastomeric silicone.

**4.** A photovoltaic concentration sub-module (1), according to claims 1 and 3, **characterised in that** the photovoltaic cells have dimensions of 5.5 x 5.5 mm.

**5.** A photovoltaic concentration sub-module (1), according to claim 1, **characterised in that** the U shaped laminar body (2) has a thickness that is equal to or less than 1 mm.

**7.** A photovoltaic concentration module (6), especially suitable for appreciably flat surfaces **characterised in that** it is made up of a plurality of sub-modules (1), according to claims 1 to 6 and arranged in a parallel and equidistant manner with each other, there being a plurality of sub-modues supported on a platform that is appreciably horizontal compared to the support surface, said platform being arranged on a support structure to be placed on a roof surface or support surface and in addition including electro-mechanical means of movement associated to the movement on two axes so as to follow the path of the sun, one of the axes being connected to the turning movement of the sub-module (1) and the other axis connected to the turning movement of the platform (7).
